# FASCICULE DE BREVET EUROPEEN

(11) **EP 2 513 978 B1**
(45) Date de publication et mention de la délivrance du brevet: **25.03.2015**
(21) Numéro de dépôt: 10809184.4
(22) Date de dépôt: 10.12.2010
(51) Int. Cl.: H01L 31/0216, H01L 31/05, H01L 31/072

(54) **CELLULE PHOTOVOLTAÏQUE A HETEROJONCTION A CONTACT ARRIERE**
HETEROÜBERGANGS-PV-ZELLE MIT RÜCKSEITIGEM KONTAKT
REAR-CONTACT HETEROJUNCTION PHOTOVOLTAIC CELL

(30) Priorité: 14.12.2009 FR 0958922
(43) Date de publication de la demande: 24.10.2012
(73) Titulaire: TOTAL MARKETING SERVICES, 92800 Puteaux (FR); Centre National de la Recherche Scientifique, 75794 Paris Cedex 16 (FR); Ecole Polytechnique, 91128 Palaiseau (FR)
(72) Inventeur: ROCA i CABARROCAS, Père, F-91140 Villebon Sur Yvette (FR); LABRUNE, Martin, F-92120 Montrouge (FR)
(74) Mandataire: Croonenbroek, Thomas Jakob
(86) Numéro de dépôt international: PCT/IB2010/055725
(87) Numéro de publication internationale: WO 2011/073868

(56) Documents cités:
- US-A- 4 703 553
- US-A- 5 538 564
- US-A- 5 641 362
- US-B1- 6 262 359

## Description

### DOMAINE DE L'INVENTION

La présente invention concerne une cellule photovoltaïque hétérojonction à contact arrière ainsi que son procédé de fabrication.

### ARRIERE-PLAN TECHNIQUE

De manière connue en soi, un module photovoltaïque comprend une pluralité de cellules photovoltaïques (ou cellules solaires) reliées en série et / ou en parallèle. Une cellule photovoltaïque est une diode semi-conductrice conçue pour absorber de l'énergie lumineuse et la convertir en énergie électrique. Cette diode semi-conductrice comprend une jonction dite PN entre deux couches de silicium dopé respectivement P et N. Lors de la formation de la jonction, une différence de potentiel (et donc un champ électrique local) apparaît, du fait de l'excès d'électrons libres dans la couche N et du défaut d'électrons libres dans la couche P.

Lorsque des photons sont absorbés par le semi-conducteur, ils cèdent leur énergie pour produire des électrons libres et des trous. Etant donné la différence de potentiel existant au niveau la jonction, les électrons libres ont tendance à s'accumuler dans la zone N et les trous à s'accumuler dans la zone P. Des électrodes de collecte en contact respectivement avec la zone N et la zone P permettent de récupérer le courant émis par la cellule photovoltaïque.

Les cellules solaires à base de silicium monocristallin ou multicristallin sont traditionnellement élaborées en prenant les contacts positifs et négatifs sur chacune des faces de la cellule. La face arrière est généralement intégralement recouverte de métal puisque seule compte la conductivité (aucune lumière ne devant traverser la face arrière), alors que la face avant, c'est-à-dire celle qui est éclairée, est contactée par une grille métallique qui permet de laisser passer la majorité de la lumière incidente.

Récemment, il a été proposé de disposer les contacts électriques uniquement en face arrière (« Rear Contacted Cells »). Cela suppose de réaliser des contacts sélectifs sur une seule face. L'avantage de cette technique est de n'avoir aucun ombrage en face avant tout en permettant de diminuer les pertes ohmiques dues aux contacts métalliques puisqu'ils recouvrent une surface de la cellule beaucoup plus grande. A cela s'ajoute le fait qu'il n'est pas nécessaire d'utiliser un oxyde transparent conducteur en face avant (aucune conduction électrique n'est nécessaire) mais plutôt du silicium amorphe et / ou un diélectrique qui a la propriété de ne pas absorber la lumière autant qu'un oxyde transparent conducteur (qui de plus est souvent composé de produits chers et / ou rares). On peut donc a priori réaliser des cellules ayant un courant de court-circuit, et donc un rendement, plus élevé.

Afin de réaliser les contacts sélectifs sur une seule face, il existe deux types de jonction possibles : le contact dit homojonction (contact cristallin / cristallin), qui peut par exemple être obtenu par diffusion de dopants sous l'effet d'une haute température (four) ; et le contact dit hétérojonction (contact cristallin / amorphe), qui peut par exemple être obtenu par dépôt de silicium amorphe hydrogéné (a-Si:H) dopé.

Le document US 2008/0035198 fournit un exemple de cellule photovoltaïque à contact arrière de type homojonction. Le document US 2007/0137692 en fournit un autre exemple, dans lequel sont prévues deux couches métalliques superposées pour la collecte des porteurs de charge respectifs, séparées l'une de l'autre et séparées du substrat par un isolant, le contact de chaque couche métallique avec le substrat étant assuré par recuit laser de la couche métallique en des emplacements ponctuels.

Les contacts de type hétérojonction présentent l'avantage d'offrir une tension de circuit ouvert plus élevée (et une perte de rendement à haute température plus faible) que les contacts de type homojonction. En outre, les contacts de type hétérojonction permettent de réaliser à la fois une passivation et une prise de contact.

Toutefois, la fabrication de cellules photovoltaïques à contact arrière de type hétérojonction reste elle-même relativement difficile à mettre en oeuvre dans la mesure où les procédés proposés jusqu'ici reposent sur un nombre élevé d'étapes, par exemple un nombre élevé d'étapes de photolithographie, technologie connue pour sa précision mais également pour son aspect difficilement industrialisable. De même les autres méthodes disponibles pour la réalisation de deux contacts de type hétérojonction en face arrière (masquage, lift-off) font également appel à un nombre d'étapes élevé et peuvent être peu pratiques à utiliser.

Par exemple, les documents WO 03/083955, WO 2006/077343, WO 2007/085072, US 2007 / 0256728, EP 1873840 décrivent tous des dispositifs semi-conducteurs à hétérojonctions comprenant un substrat de silicium cristallin recouvert sur une même face arrière par des zones respectives de silicium amorphe dopé N et de silicium amorphe dopé P, qui sont séparées par des portions isolantes, et qui sont recouvertes de zones de métallisation respectives destinées à la collecte des porteurs de charge.

Un inconvénient de tous ces dispositifs est que leur fabrication nécessite deux étapes distinctes de dépôt de silicium amorphe, par exemple en utilisant un masque à chaque étape ou encore en déposant d'abord l'un des siliciums amorphes, puis en le gravant avant de déposer l'autre silicium amorphe.

Par conséquent, il existe un réel besoin de mettre au point un dispositif semi-conducteur adapté à fonctionner comme une cellule photovoltaïque, susceptible d'être fabriqué selon un procédé plus simple, avec un nombre réduit d'étapes et pouvant être mis en oeuvre à l'échelle industrielle.

Le préambule de la revendication 1 est connu du document US 5,641,362.

### RESUME DE L'INVENTION

L'invention concerne en premier lieu un dispositif semi-conducteur comprenant les caractéristiques de la revendication 1.

Selon un mode de réalisation, la deuxième zone de métallisation comprend de l'aluminium, et de préférence la première zone de métallisation comprend également de l'aluminium.

Selon un mode de réalisation, la première zone de métallisation et la deuxième zone de métallisation forment une structure interdigitée.

Selon un mode de réalisation, le dispositif semi-conducteur comprend une couche anti-réflective disposée sur la couche de passivation avant, comprenant de préférence du nitrure de silicium amorphe hydrogéné.

L'invention a également pour objet un module de cellules photovoltaïques, comportant plusieurs cellules photovoltaïques telles que décrites ci-dessus, connectées en série ou en parallèle.

L'invention a également pour objet un procédé de fabrication d'un dispositif semi-conducteur comprenant les caractéristiques de la revendication 6.

Selon un mode de réalisation, la deuxième zone de métallisation comprend de l'aluminium, et de préférence la première zone de métallisation comprend également de l'aluminium.

Selon un mode de réalisation, la formation de la première zone de métallisation et la formation de la partie de surface de la deuxième zone de métallisation sont effectuées par lithographie ou évaporation à travers un masque ou pulvérisation à travers un masque ou sérigraphie, et sont de préférence effectuées simultanément ; et dans lequel la première zone de métallisation et la deuxième zone de métallisation forment de préférence une structure interdigitée.

Selon un mode de réalisation, le procédé comprend la formation d'une couche anti-réflective sur la couche de passivation avant, ladite couche anti-réflective comprenant de préférence du nitrure de silicium amorphe hydrogéné.

L'invention a également pour objet un procédé de fabrication d'un module de cellules photovoltaïques, comprenant la connexion en série ou en parallèle de plusieurs cellules photovoltaïques telles que décrites ci-dessus.

La présente invention permet de surmonter les inconvénients de l'état de la technique. Elle fournit plus particulièrement un dispositif semi-conducteur adapté à fonctionner comme une cellule photovoltaïque, susceptible d'être fabriqué selon un procédé plus simple, avec un nombre réduit d'étapes et pouvant être mis en oeuvre à l'échelle industrielle.

Cela est accompli grâce à la mise au point d'un dispositif semi-conducteur à contact arrière, tel que décrit ci-dessus.

Ce dispositif semi-conducteur peut en effet être obtenu avec une seule étape de dépôt de silicium amorphe dopé sur la face arrière et une seule étape de dépôt de matière métallique de collecte des porteurs de charge sur la face arrière.

Selon certains modes de réalisation particuliers, l'invention présente également une ou de préférence plusieurs des caractéristiques avantageuses énumérées ci-dessous.
- L'invention fournit des cellules photovoltaïques à contact arrière, c'est à dire ne présentant pas d'ombrage en face avant, et présentant des pertes ohmiques dues aux contacts métalliques minimales ; en outre, l'invention permet de se dispenser de tout oxyde transparent conducteur en face avant, ce qui permet un courant de court-circuit, et donc un rendement, élevé.
- Les dispositifs semi-conducteurs de l'invention présentent un contact N de type hétérojonction (c'est-à-dire un contact avec une région de silicium amorphe), ce qui garantit une très bonne passivation ; et un contact P de type homojonction, qui combiné au premier permet de recourir à un procédé de fabrication grandement simplifié sans trop dégrader la passivation globale.
- L'utilisation de la technique du recuit laser pour réaliser les contacts de type P permet de n'endommager la couche de passivation sur la face arrière que de manière très limitée (c'est à dire au niveau des contacts de type P eux-mêmes), car le chauffage par le laser est très localisé sur la surface. La couche de passivation reste intacte au niveau des contacts de type N et entre les contacts de type N et les contacts de type P.

### BREVE DESCRIPTION DES FIGURES

La **Figure 1** représente de manière schématique un mode de réalisation d'un dispositif semi-conducteur (notamment une cellule photovoltaïque) selon l'invention, en cours de fabrication, en coupe (et en vue partielle). Les différentes couches de matériau ne sont pas à l'échelle sur la figure.
La **Figure 2** représente ce dispositif semi-conducteur à la fin de sa fabrication, en coupe également et toujours en vue partielle.
La **Figure 3** représente une vue de la face arrière de ce dispositif semi-conducteur à la fin de sa fabrication.
La **Figure 4** représente une vue partielle de ce dispositif, en coupe longitudinale correspondant à la ligne A-A sur **la** **Figure 3****.**

### DESCRIPTION DE MODES DE REALISATION DE L'INVENTION

L'invention est maintenant décrite plus en détail et de façon non limitative dans la description qui suit, en se référant à l'application photovoltaïque de l'invention.

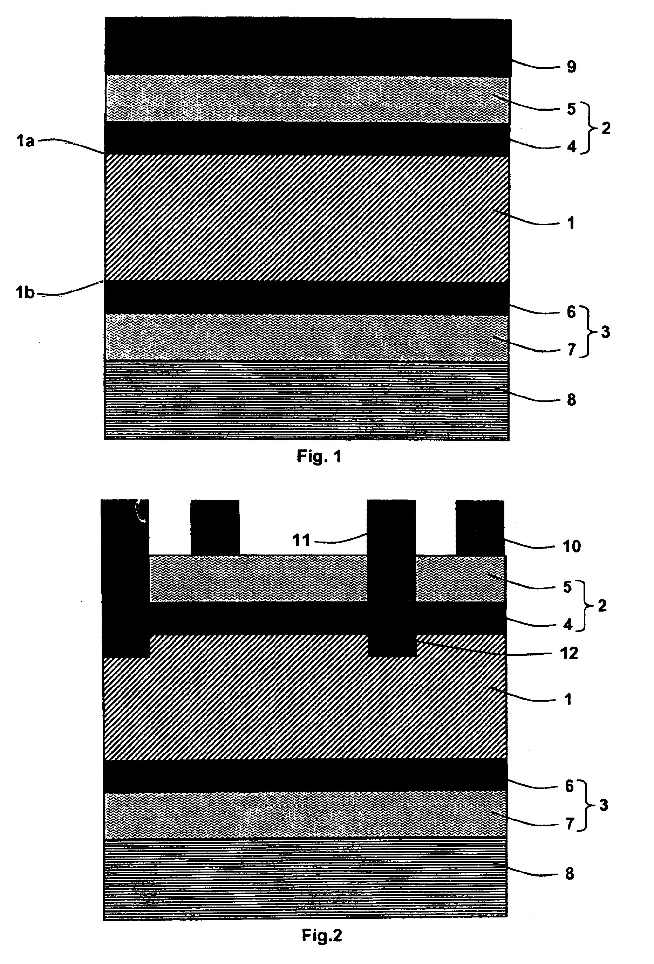

En faisant référence à la **Figure 1****,** un dispositif semi-conducteur selon l'invention peut être fabriqué comme suit.

Tout d'abord, on fournit un substrat semi-conducteur cristallin 1 présentant une face avant 1b et une face arrière 1a. De préférence, le substrat semi-conducteur cristallin 1 est un substrat (ou " wafer ") de silicium cristallin, notamment monocristallin ou polycristallin (de préférence monocristallin), en forme de plaque.

Ce substrat peut être dopé de type N ou P. L'utilisation d'un substrat dopé de type N est particulièrement avantageuse dans la mesure où le temps de vie de ce substrat est plus élevé. Dans la suite, on prend pour exemple un substrat dopé de type N. Le substrat 1 est avantageusement dépourvu de tout matériau oxyde.

De préférence, le substrat 1 présente un dopage suffisant pour présenter une résistivité comprise entre environ 0,1 et 1 Ω.cm.

De part et d'autre du substrat 1, c'est-à-dire sur sa face avant 1b et sur sa face arrière 1a, on applique respectivement une couche de passivation avant 3 et une couche de passivation arrière 2.

La couche de passivation avant 3 comprend avantageusement une couche de silicium hydrogéné intrinsèque amorphe 6 en contact avec le substrat 1 et une couche de silicium amorphe hydrogéné dopé 7 disposée sur celle-ci. La couche de silicium amorphe hydrogéné dopé 7 est dopée N lorsque le substrat 1 est de type N ; ou bien elle est dopée P lorsque le substrat 1 est de type P.

De manière symétrique, la couche de passivation arrière 2 comprend avantageusement une couche de silicium hydrogéné intrinsèque amorphe 4 en contact avec le substrat 1 et une couche de silicium amorphe hydrogéné dopé 5 disposée sur celle-ci. De préférence la couche de silicium amorphe hydrogéné dopé 5 est dopée N, quel que soit le type de dopage du substrat 1.

Les couches de passivation avant 3 et arrière 2 jouent un rôle de passivation de deux façons complémentaires : d'une part la présence de silicium amorphe sur chaque face 1a, 1b du substrat cristallin permet de rendre inactifs les défauts de surface du substrat, en évitant les liaisons pendantes à la surface, ce qui évite la recombinaison des porteurs de charge avant leur collecte ; d'autre part la présence des couches de silicium amorphe hydrogéné dopé 5, 7 permet de créer un champ de surface avant, respectivement un champ de surface arrière, qui améliorent également la collecte des porteurs de charge.

Le dépôt des deux couches de silicium amorphe hydrogéné intrinsèque 4, 6 et des deux couches de silicium amorphe hydrogéné dopé 5, 7 peut être effectué par exemple selon la technique du dépôt chimique en phase vapeur assisté par plasma (PECVD) ou selon la technique du dépôt chimique en phase vapeur faible pression (LPCVD). Chacune des couches peut couvrir la totalité de la surface du substrat 1.

Sur la couche de passivation avant 3, on dispose avantageusement une couche anti-réflective 8. Celle-ci comprend un matériau diélectrique, de préférence du nitrure de silicium amorphe hydrogéné. De préférence, elle s'étend sur toute la surface de la couche de passivation avant 3. Elle peut être déposée par exemple selon la technique PECVD ou LPCVD. Le rôle principal de la couche anti-réflective est d'éliminer au maximum la réflexion de la lumière arrivant sur le dispositif par le côté avant. L'indice de réfraction de la couche anti-réflective pourra par exemple être voisin de 2. On peut utiliser un silicium texturé pour améliorer la collecte de la lumière.

Sur la couche de passivation arrière 2, on procède au dépôt d'une couche métallique 9. On peut par exemple procéder par évaporation, pulvérisation ou par dépôt électrochimique. La couche métallique 9 est de préférence à base d'aluminium. Selon le mode de réalisation représenté sur la **Figure 1****, la** couche métallique 9 recouvre initialement toute la surface de la couche de passivation arrière 2 ; puis, on enlève sélectivement une partie de la couche métallique 9 (par gravure ou autre) afin d'obtenir une première zone de métallisation 10 et une deuxième zone de métallisation 11 séparée de la première zone de métallisation 10.

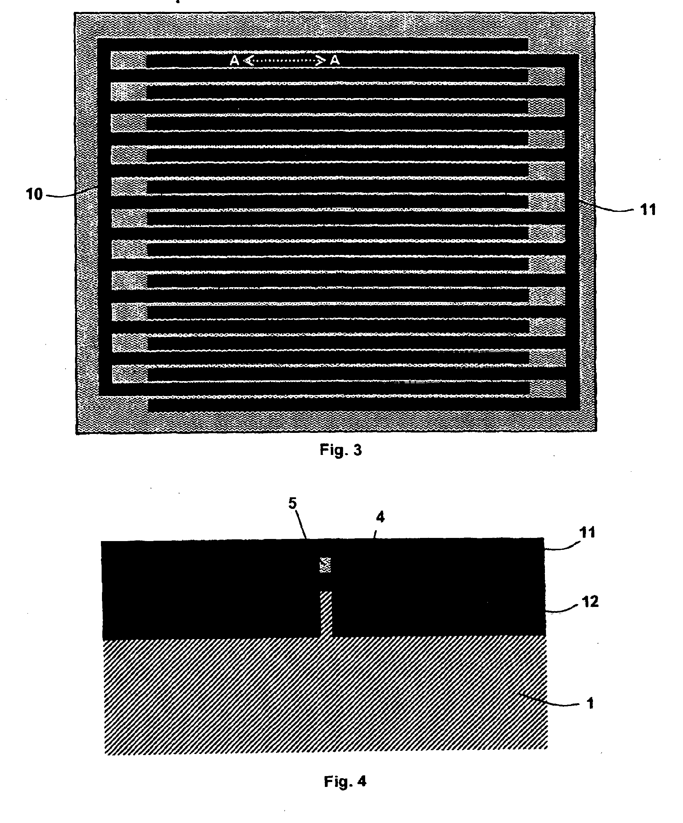

De préférence, la première zone de métallisation 10 et la deuxième zone de métallisation 11 forment une structure interdigitée telle que représentée sur la **Figure 3****,** c'est-à-dire une structure où les deux zones de métallisation 10, 11 forment des peignes inversés et imbriqués. Les zones de métallisation 10, 11 sont destinées à la collecte des porteurs de charge respectifs. Une structure interdigitée permet une connexion électrique du dispositif particulièrement simple.

Alternativement, on peut également appliquer directement les zones de métallisation 10, 11 de façon sélective à la surface de la couche de passivation arrière 2, de sorte à obtenir directement le motif (par exemple interdigité) souhaité. Pour ce faire, on peut utiliser la sérigraphie de pâte métallique, à travers un masque de forme appropriée ou encore l'évaporation ou la pulvérisation à travers un masque.

Selon le mode de réalisation principal décrit ci-dessus, les zones de métallisation 10, 11 sont réalisées à partir d'un même matériau (de préférence à base d'aluminium) : ce mode de réalisation est en effet le plus simple à mettre en oeuvre. Toutefois, il est également possible de préparer des zones de métallisation 10, 11 de composition différentes l'une de l'autre. Dans ce cas, au moins la deuxième zone de métallisation 11 est de préférence à base d'aluminium.

On procède ensuite à une étape de recuit laser (ou « laser firing ») de la deuxième zone de métallisation 11. Le recuit laser consiste à appliquer des impulsions laser sur la deuxième zone de métallisation 11 de sorte à induire pendant un temps très court un cycle de fusion / solidification sur la deuxième zone de métallisation 11 ainsi que sur une certaine épaisseur du silicium sous-jacent. Pendant la phase de fusion, le métal (notamment aluminium) diffuse rapidement dans le silicium liquide. Pendant la phase de solidification, le silicium est à nouveau épitaxié à partir du silicium solide sous-jacent ; les atomes (dopants) du métal (notamment aluminium) ayant diffusé pendant le cycle de fusion sont alors mis en sites substitutionnels dans le cristal reconstruit.

Ainsi, et en faisant référence à la **Figure 2****,** à l'issue du recuit laser, la deuxième zone de métallisation comprend d'une part une partie de surface 11, disposée sur la couche de passivation arrière 3 et qui correspond essentiellement à la deuxième zone de métallisation avant recuit laser ; et d'autre part une partie interne 12 traversant la couche de passivation arrière 2 et pénétrant dans le substrat 1, cette partie interne 12 étant obtenue par diffusion des atomes (notamment d'aluminium) lors du recuit laser.

La partie interne 12 de la deuxième zone de métallisation comprend donc une région du substrat 1, située en dessous de la partie de surface 11 de la deuxième zone de métallisation, qui est dopée de type P+ (c'est-à-dire qui présente une forte concentration de dopants de type P, notamment atomes d'aluminium). Autrement dit, la partie interne 12 de la deuxième zone de métallisation forme ainsi dans le substrat 1 une région dans laquelle la concentration en accepteurs d'électrons est supérieure au reste du substrat 1, et ce, que le substrat 1 soit de type N ou de type P. Lorsque le substrat 1 est de type N, on forme ainsi une jonction de type PN entre la région du substrat 1 modifiée par recuit laser et le reste du substrat 1 ; et lorsque le substrat 1 est de type P, on forme ainsi une jonction de type PP+.

L'extrême rapidité du front de solidification lors du recuit laser favorise la formation de profils carrés, et permet d'atteindre des taux d'activation supérieurs à ceux obtenus avec des techniques classiques. Selon cette technique, l'énergie laser détermine l'épaisseur de la région du substrat 1 ainsi dopée. A la suite du traitement laser, les dopants sont électriquement actifs, le profil de dopage est quasi-carré, avec des flancs très abrupts.

Les documents suivants fournissent des exemples de mise en oeuvre de la technique du recuit laser :
- Laser fired back contact for silicon cells, Tucci et al., Thin solid films 516:6767-6770 (2008);
- Laser fired contacts on amorphous silicon deposited by hot-wire CVD on crystalline silicon, Blanqué et al., 23rd European photovoltaic solar energy conference, 1-5 septembre 2008, Valence (Espagne), p.1393-1396;
- Bragg reflector and laser fired back contact in a-Si:H/c-Si heterostructure, Tucci et al., Materials Science and Engineering B 159-160:48-52 (2009).

Typiquement, on pourra utiliser un *laser* pulsé Nd-YAG ou un laser excimère UV pulsé. A titre d'exemple, on pourra utiliser un *laser* déclenché Nd-YAG à 1064 nm en mode TEM₀₀, avec une puissance de 300 à 900 mW et une durée d'impulsion de 100 ms avec une fréquence de répétition de 1 kHz.

De manière générale, la puissance du laser et la durée d'impulsion sont ajustées en fonction de la profondeur du recuit et du dopage induit souhaités. La vitesse de défilement du laser et la fréquence sont ajustées pour ajuster la distance entre les impacts laser.

Lorsque la partie de surface 11 de la deuxième zone de métallisation présente un motif de bandes, comme c'est le cas dans le cadre d'une structure interdigitée, la distance entre les impacts laser le long des bandes du motif (voir la **Figure 4**) doit être suffisamment faible afin de limiter les pertes ohmiques et d'optimiser la collecte des charges.

A l'issue du recuit laser :
- La première zone de métallisation 10 reste présente uniquement au-dessus de la couche de passivation arrière 2 et plus précisément au-dessus de la couche de silicium amorphe hydrogéné 5 dopé N. Par conséquent, cette première zone de métallisation 10 assure un contact de type N, c'est-à-dire est adaptée à la collecte des électrons.
- La deuxième zone de métallisation a été transformée en contact de type P, c'est-à-dire qu'elle est adaptée à la collecte des trous.

A titre indicatif, la géométrie du dispositif semi-conducteur ainsi obtenu peut être la suivante :
- Substrat 1 : épaisseur comprise entre 150 et 300 µm.
- Couches de silicium amorphe hydrogéné intrinsèque 4, 6: épaisseur comprise entre 1 et 10 nm, notamment entre 3 et 5 nm.
- Couches de silicium amorphe hydrogéné dopé 5, 7 : épaisseur comprise entre 5 et 30 nm, notamment entre 5 et 15 nm.
- Couche anti-réflective 8 : épaisseur comprise entre 50 et 100 nm.
- Première zone de métallisation 10 et partie de surface 11 de la deuxième zone de métallisation : épaisseur comprise entre 2 et 30 µm, notamment entre 2 et 10 µm.

Si les deux zones de métallisation ont une forme interdigitée, comme cela est représenté ici, ces zones de métallisation comprennent des bandes parallèles disposées en alternance. Chaque bande peut avoir une largeur typique de 50 à 400 µm et notamment de 50 à 200 µm (par exemple environ 100 µm) et deux bandes peuvent être séparées par une distance typique de 50 à 200 µm (par exemple environ 100 µm).

La longueur de diffusion des porteurs de charge dans la couche de passivation arrière 2 est typiquement d'environ 20 nm du fait de la présence de silicium amorphe dopé. Par conséquent les porteurs de charge peuvent traverser la couche de passivation arrière 2 selon son épaisseur, mais ne peuvent essentiellement pas la traverser selon une direction parallèle à la face arrière 1b du substrat 1. Par conséquent, il n'y a pratiquement pas de court circuit possible entre les deux zones de métallisation respectives.

La description ci-dessus a trait à des dispositifs semi-conducteurs qui sont généralement utilisés en tant que cellules photovoltaïques. Un ou plusieurs de ces dispositifs peuvent être incorporés sous la forme d'un module de cellules photovoltaïques. Par exemple, un certain nombre de cellules photovoltaïques peuvent être reliées électriquement, en série et / ou en parallèle, pour former le module.

Le module peut être fabriqué de différentes façons. Par exemple, il est possible de disposer des cellules photovoltaïques entre des plaques de verre, ou entre une plaque de verre et une plaque de résine transparente, par exemple en éthylène acétate de vinyle. Si toutes les cellules photovoltaïques ont leur face avant orientée dans le même sens, on peut également utiliser une plaque non-transparente (métallique, céramique ou autre) du côté arrière. On peut également fabriquer des modules recevant la lumière sur deux faces opposées (voir par exemple le document US 6,667,434 à cet égard). Une résine de scellement peut être prévue pour sceller les côtés du module et le protéger de l'humidité atmosphérique. Diverses couches de résine peuvent également être prévues pour empêcher la diffusion indésirable de sodium issu des plaques de verre.

Le module comprend en outre généralement des moyens de conversion statique aux bornes des cellules photovoltaïques. Selon les applications, il peut s'agir de moyens de conversion courant continu - courant alternatif (DC/AC) et / ou de moyens de conversion courant continu - courant continu (DC/DC). Les moyens de conversion statique sont adaptés à transmettre la puissance électrique fournie par les cellules photovoltaïques vers une charge d'une application extérieure - batterie, réseau électrique ou autre. Ces moyens de conversion statique sont adaptés à diminuer le courant transmis et à augmenter la tension transmise. Les moyens de conversion statique peuvent être associés à une électronique de gestion.

Les détails de fabrication du module solaire (éléments de support, de cadre, connexions électriques, encapsulation...) sont bien connus de l'homme du métier.

## Revendications

1. Cellule photovoltaïque comprenant :
- un substrat semi-conducteur cristallin (1) présentant une face avant (1b) et une face arrière (1a) ;
- une couche de passivation avant (3) disposée sur la face avant (1b) du substrat (1) ;
- une couche de passivation arrière (2) disposée sur la face arrière (1a) du substrat (1) ;
- une première zone de métallisation (10) disposée sur la couche de passivation arrière (2) et adaptée à la collecte des électrons ;
- une deuxième zone de métallisation adaptée à la collecte des trous, comprenant
* une partie de surface (11) disposée sur la couche de passivation arrière (2); et
* une partie interne (12) traversant la couche de passivation arrière (2) et formant dans le substrat (1) une région dans laquelle la concentration en accepteurs d'électrons est supérieure au reste du substrat (1),
le substrat semi-conducteur cristallin (1) étant un substrat de silicium cristallin dopé de type N ou P, la cellule photovoltaïque étant **caractérisée en ce que**
la couche de passivation avant (3) comprend :
- une couche de silicium amorphe hydrogéné intrinsèque (6) en contact avec le substrat (1) ; et
- une couche de silicium amorphe hydrogéné dopé (7) disposée sur celle-ci, présentant un dopage de type P si le substrat (1) est de type P, ou un dopage de type N si le substrat (1) est de type N ; et / ou la couche de passivation arrière (2) comprend :
- une couche de silicium amorphe hydrogéné intrinsèque (4) en contact avec le substrat (1) ; et
- une couche de silicium amorphe hydrogéné dopé (5) disposée sur celle-ci, présentant un dopage de type N.

2. Cellule photovoltaïque selon la revendication 1, dans laquelle la deuxième zone de métallisation (11, 12) comprend de l'aluminium, et de préférence la première zone de métallisation (10) comprend également de l'aluminium.

3. Cellule photovoltaïque selon l'une des revendications 1 à 2, dans laquelle la première zone de métallisation (10) et la deuxième zone de métallisation (11, 12) forment une structure interdigitée.

4. Cellule photovoltaïque selon l'une des revendications 1 à 3, comprenant une couche anti-réflective (8) disposée sur la couche de passivation avant (3), comprenant de préférence du nitrure de silicium amorphe hydrogéné.

5. Module de cellules photovoltaïques, comportant plusieurs cellules photovoltaïques selon l'une quelconque des revendications 1 à 4 connectées en série ou en parallèle.

6. Procédé de fabrication d'une cellule photovoltaïque comprenant :
- la fourniture d'un substrat semi-conducteur cristallin (1) présentant une face avant (1b) et une face arrière (1a) ;
- la formation d'une couche de passivation avant (3) sur la face avant (1b) du substrat (1) ;
- la formation d'une couche de passivation arrière (2) sur la face arrière (1a) du substrat (1) ;
- la formation d'une première zone de métallisation (10) sur la couche de passivation arrière (2), adaptée à la collecte des électrons ;
- la formation d'une deuxième zone de métallisation, comprenant :
* la formation d'une partie de surface (11) de la deuxième zone de métallisation (10) sur la couche de passivation arrière (2), adaptée à la collecte des trous ;
* la formation d'une partie interne (12) de la deuxième zone de métallisation, qui traverse la couche de passivation arrière (2) et forme dans le substrat (1) une région présentant une concentration en accepteurs d'électrons supérieure au reste du substrat (1), par recuit laser de la partie de surface (11) de la deuxième zone de métallisation,
- dans lequel le substrat semiconducteur cristallin (1) est un substrat de silicium cristallin dopé de type N ou P, et
dans lequel :
- la formation de la couche de passivation avant (3) sur la face avant (1b) du substrat (1) comprend la formation d'une couche de silicium amorphe hydrogéné intrinsèque (6) en contact avec le substrat (1) ; et la formation d'une couche de silicium amorphe hydrogéné dopé (7) sur celle-ci, présentant un dopage de type P si le substrat (1) est de type P, ou un dopage de type N si le substrat (1) est de type N ; et / ou
- la formation de la couche de passivation arrière (2) sur la face arrière (1a) du substrat (1) comprend la formation d'une couche de silicium amorphe hydrogéné intrinsèque (4) en contact avec le substrat (1) ; et la formation d'une couche de silicium amorphe hydrogéné dopé (5) présentant un dopage de type N sur celle-ci.

7. Procédé selon la revendication 6, dans lequel la deuxième zone de métallisation (11, 12) comprend de l'aluminium, et de préférence la première zone de métallisation (10) comprend également de l'aluminium.

8. Procédé selon l'une des revendications 6 ou 7, dans lequel la formation de la première zone de métallisation (10) et la formation de la partie de surface (11) de la deuxième zone de métallisation sont effectuées par lithographie ou évaporation à travers un masque ou pulvérisation à travers un masque ou sérigraphie, et sont de préférence effectuées simultanément ; et dans lequel la première zone de métallisation (10) et la deuxième zone de métallisation (11,12) forment de préférence une structure interdigitée.

9. Procédé selon l'une des revendications 6 à 8, comprenant la formation d'une couche anti-réflective (8) sur la couche de passivation avant (3), ladite couche anti-réflective (8) comprenant de préférence du nitrure de silicium amorphe hydrogéné.

10. Procédé de fabrication d'un module de cellules photovoltaïques, comprenant la connexion en série ou en parallèle de plusieurs cellules photovoltaïques selon l'une des revendications 1 à 4.

## Patentansprüche

1. Photovoltaikzelle, die enthält:
- ein kristallines Halbleitersubstrat (1), das eine Vorderseite (1b) und eine Rückseite (1a) aufweist;
- eine vordere Passivierungsschicht (3), die an der Vorderseite (1b) des Substrats (1) angeordnet ist;
- eine hintere Passivierungsschicht (2), die an der Rückseite (1a) des Substrats (1) angeordnet ist;
- eine erste Metallisierungszone (10), die auf der hinteren Passivierungsschicht (2) angeordnet und zum Sammeln der Elektronen geeignet ist;
- eine zweite Metallisierungszone, die zum Sammeln der Löcher geeignet ist, die enthält:
* einen Oberflächenteil (11), der auf der hinteren Passivierungsschicht (2) angeordnet ist; und
* einen inneren Teil (12), der die hintere Passivierungsschicht (2) durchquert und im Substrat (1) einen Bereich formt, in dem die Konzentration an Elektronenakzeptoren höher ist als im Rest des Substrats (1),
wobei das kristalline Halbleitersubstrat (1) ein Substrat aus dotiertem kristallinem Silicium vom n- oder p-Typ ist,
wobei die Photovoltaikzelle **dadurch gekennzeichnet** ist, dass die vordere Passivierungsschicht (3) enthält:
- eine Schicht aus intrinsischem hydriertem amorphem Silicium (6) in Kontakt mit dem Substrat (1); und
- eine auf dieser angeordnete Schicht aus dotiertem hydriertem amorphem Silicium (7), das eine Dotierung vom p-Typ, wenn das Substrat (1) vom p-Typ ist, oder eine Dotierung vom n-Typ aufweist, wenn das Substrat (1) vom n-Typ ist;
und/oder die hintere Passivierungsschicht (2) enthält:
- eine Schicht aus intrinsischem hydriertem amorphem Silicium (4) in Kontakt mit dem Substrat (1); und
- eine auf dieser angeordnete Schicht aus dotiertem hydriertem amorphem Silicium (5), das eine Dotierung vom n-Typ aufweist.

2. Photovoltaikzelle nach Anspruch 1, wobei die zweite Metallisierungszone (11, 12) Aluminium enthält, und vorzugsweise die erste Metallisierungszone (10) ebenfalls Aluminium enthält.

3. Photovoltaikzelle nach einem der Ansprüche 1 bis 2, wobei die erste Metallisierungszone (10) und die zweite Metallisierungszone (11, 12) eine interdigitale Struktur formen.

4. Photovoltaikzelle nach einem der Ansprüche 1 bis 3, die eine auf der vorderen Passivierungsschicht (3) angeordnete Antireflexschicht (8) enthält, die vorzugsweise hydriertes amorphes Siliciumnitrid enthält.

5. Modul von Photovoltaikzellen, das mehrere Photovoltaikzellen nach einem der Ansprüche 1 bis 4 in Reihe oder parallel geschaltet aufweist.

6. Verfahren zur Herstellung einer Photovoltaikzelle, das enthält:
- die Bereitstellung eines kristallinen Halbleitersubstrats (1), das eine Vorderseite (1b) und eine Rückseite (1a) aufweist;
- das Formen einer vorderen Passivierungsschicht (3) an der Vorderseite (1b) des Substrats (1);
- das Formen einer hinteren Passivierungsschicht (2) an der Rückseite (1a) des Substrats (1);
- das Formen einer ersten Metallisierungszone (10) auf der hinteren Passivierungsschicht (2), die zum Sammeln der Elektronen geeignet ist;
- das Formen einer zweiten Metallisierungszone, das enthält:
das Formen eines Oberflächenteils (11) der zweiten Metallisierungszone (10) auf der hinteren Passivierungsschicht (2), der zum Sammeln der Löcher geeignet ist;
* das Formen eines inneren Teils (12) der zweiten Metallisierungszone, der die hintere Passivierungsschicht (2) durchquert und im Substrat (1) einen Bereich formt, der eine höhere Konzentration an Elektronenakzeptoren als im Rest des Substrats (1) aufweist, durch Laserglühen des Oberflächenteils (11) der zweiten Metallisierungszone,
- wobei das kristalline Halbleitersubstrat (1) ein Substrat aus dotiertem kristallinem Silicium des n- oder p-Typs ist, und
- wobei:
* das Formen der vorderen Passivierungsschicht (3) an der Vorderseite (la) des Substrats (1) das Formen einer Schicht aus intrinsischem hydriertem amorphem Silicium (6) in Kontakt mit dem Substrat (1) und das Formen einer Schicht aus dotiertem hydriertem amorphem Silicium (7) auf dieser enthält, die eine Dotierung vom p-Typ, wenn das Substrat (1) vom p-Typ ist, oder eine Dotierung vom n-Typ aufweist, wenn das Substrat (1) vom n-Typ ist; und/oder
* das Formen der hinteren Passivierungsschicht (2) an der Rückseite (1a) des Substrats (1) das Formen einer Schicht aus intrinsischem hydriertem amorphem Silicium (4) in Kontakt mit dem Substrat (1) und das Formen einer Schicht aus dotiertem hydriertem amorphem Silicium (5) mit einer Dotierung vom n-Typ auf dieser enthält.

7. Verfahren nach Anspruch 6, wobei die zweite Metallisierungszone (11, 12) Aluminium enthält, und vorzugsweise die erste Metallisierungszone (10) ebenfalls Aluminium enthält.

8. Verfahren nach einem der Ansprüche 6 oder 7, wobei das Formen der ersten Metallisierungszone (10) und das Formen des Oberflächenteils (11) der zweiten Metallisierungszone durch Lithographie oder Verdampfen durch eine Maske oder Zerstäubung durch eine Maske oder Siebdruck durchgeführt werden, und vorzugsweise gleichzeitig durchgeführt werden; und wobei die erste Metallisierungszone (10) und die zweite Metallisierungszone (11, 12) vorzugsweise eine interdigitale Struktur formen.

9. Verfahren nach einem der Ansprüche 6 bis 8, das das Formen einer Antireflexschicht (8) auf der vorderen Passivierungsschicht (3) enthält, wobei die Antireflexschicht (8) vorzugsweise hydriertes amorphes Siliciumnitrid enthält.

10. Verfahren zur Herstellung eines Moduls von Photovoltaikzellen, das die Reihen- oder Parallelschaltung mehrerer Photovoltaikzellen nach einem der Ansprüche 1 bis 4 enthält.

## Claims

1. Photovoltaic cell comprising:
- a crystalline semiconductor substrate (1) having a front face (1b) and a back face (1a) ;
- a front passivation layer (3) positioned on the front face (1b) of the substrate (1);
- a back passivation layer (2) positioned on the back face (1a) of the substrate (1);
- a first metallization zone (10) positioned on the back passivation layer (2) and suitable for collecting electrons;
- a second metallization zone suitable for collecting holes, comprising:
• a surface portion (11) positioned on the back passivation layer (2); and
• an inner portion (12) passing through the back passivation layer (2) and forming, in the substrate (1), a region in which the concentration of electron acceptors is greater than the rest of the substrate (1),
the crystalline semiconductor substrate (1) being a n-type or p-type doped crystalline silicon substrate,
the photovoltaic cell being **characterized in that** the front passivation layer (3) comprises:
- a layer of intrinsic hydrogenated amorphous silicon (6) in contact with the substrate (1); and
- a layer of doped hydrogenated amorphous silicon (7) positioned on the latter, having p-type doping if the substrate (1) is of p type, or n-type doping if the substrate (1) is of n-type; and/or the back passivation layer (2) comprises:
- a layer of intrinsic hydrogenated amorphous silicon (4) in contact with the substrate (1); and
- a layer of doped hydrogenated amorphous silicon (5) positioned on the latter, having n-type doping.

2. Photovoltaic cell according to Claim 1, wherein the second metallization zone (11, 12) comprises aluminium, and preferably the first metallization zone (10) also comprises aluminium.

3. Photovoltaic cell according to either of Claims 1 and 2, wherein the first metallization zone (10) and the second metallization zone (11, 12) form an interdigitated structure.

4. Photovoltaic cell according to one of Claims 1 to 3 , comprising an antireflective layer (8) positioned on the front passivation layer (3), preferably comprising hydrogenated amorphous silicon nitride.

5. Module of photovoltaic cells, comprising several photovoltaic cells according to any one of Claims 1 to 4 connected in series or in parallel.

6. Process for manufacturing a photovoltaic cell comprising:
- the provision of a crystalline semiconductor substrate (1) having a front face (1b) and a back face (1a);
- the formation of a front passivation layer (3) on the front face (1b) of the substrate (1);
- the formation of a back passivation layer (2) on the back face (1a) of the substrate (1);
- the formation of a first metallization zone (10) on the back passivation layer (2), suitable for collecting electrons;
- the formation of a second metallization zone, comprising:
• the formation of a surface portion (11) of the second metallization zone (10) on the back passivation layer (2), suitable for collecting holes;
• the formation of an inner portion (12) of the second metallization zone, which passes through the back passivation layer (2) and forms in the substrate (1) a region having a concentration of electron acceptors greater than the rest of the substrate (1), by laser annealing of the surface portion (11) of the second metallization zone,
- wherein the crystalline semiconductor substrate (1) is a n-type or p-type doped crystalline silicon substrate, and
- wherein:
• the formation of the front passivation layer (3) on the front face (1b) of the substrate (1) comprises the formation of a layer of intrinsic hydrogenated amorphous silicon (6) in contact with the substrate (1); and the formation of a layer of doped hydrogenated amorphous silicon (7) on the latter, having p-type doping if the substrate (1) is of p-type, or n-type doping if the substrate (1) is of n-type; and/or
• the formation of the back passivation layer (2) on the back face (1a) of the substrate (1) comprises the formation of a layer of intrinsic hydrogenated amorphous silicon (4) in contact with the substrate (1); and the formation of a layer of doped hydrogenated amorphous silicon (5) having n-type doping on the latter.

7. Process according to Claim 6, wherein the second metallization zone (11, 12) comprises aluminium, and preferably the first metallization zone (10) also comprises aluminium.

8. Process according to either of Claims 6 and 7, wherein the formation of the first metallization zone (10) and the formation of the surface portion (11) of the second metallization zone are carried out by lithography or evaporation through a mask or spraying through a mask or screen printing, and are preferably carried out simultaneously; and wherein the first metallization zone (10) and the second metallization zone (11, 12) preferably form an interdigitated structure.

9. Process according to one of Claims 6 to 8, comprising the formation of an antireflective layer (8) on the front passivation layer (3), said antireflective layer (8) preferably comprising hydrogenated amorphous silicon nitride.

10. Process for manufacturing a module of photovoltaic cells, comprising the connection, in series or in parallel, of several photovoltaic cells according to one of Claims 1 to 4.
